(19) Europäisches Patentamt

European Patent Office

Office européen des brevets

(11) **EP 1 420 297 A2**

(12) **EUROPEAN PATENT APPLICATION**

(43) Date of publication:
**19.05.2004 Bulletin 2004/21**

(51) Int Cl.7: **G03F 7/20**

(21) Application number: **03078628.9**

(22) Date of filing: **11.11.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **13.11.2002 EP 02079722**

(71) Applicant: **ASML Netherlands B.V.
5503 LA Veldhoven (NL)**

(72) Inventor: **Teeuwen, Leonardus Johannes Hendrikus G.W.
5953 MZ Reuver (NL)**

(74) Representative:
**Prins, Adrianus Willem, Mr. Ir. et al
Vereenigde,
Nieuwe Parklaan 97
2587 BN Den Haag (NL)**

(54) **Lithographic apparatus and method to determine beam size and divergence**

(57) A lithographic apparatus comprises a radiation system for providing a projection beam of radiation; an aperture, through which a radiation beam is directed; a detector for measuring an intensity of the radiation beam through said aperture; a focussing element; and means for directing the radiation beam through said aperture. The lithographic apparatus according to the invention comprises a processing unit coupled to said means for directing the radiation beam in order to vary the intensity of said radiation beam through said aperture by a relative movement or a change in pointing direction of the radiation beam, the processing unit further coupled to said detector for measuring said intensity, the processor arranged to calculate the beam size or beam divergence from the measured intensity and relative movement. The apparatus of the invention offers a simple and reliable possibility for determining beam quality characteristics such as beam size and/or beam divergence.

Fig. 2

**Description**

The present invention relates to a lithographic apparatus and the application of a method in a lithographic apparatus comprising:

- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate;
- an aperture, through which a radiation beam is directed;
- a detector for measuring an intensity of the radiation beam through said aperture; and
- means for changing a position or a pointing direction of the radiation beam.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic apparatus, each target portion is irradiated by exposing the entire mask pattern onto the target portion in one go; such an apparatus is commonly referred to as a wafer stepper or step-and-repeat apparatus. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic apparatus as here described can be gleaned, for example, from US 6,046,792, incorporated herein by reference.

In a manufacturing process using a lithographic apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/ inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling an incoming radiation beam, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

Developments in the field of lithograpy for improving projection image quality have demonstrated the necessity of improving several characteristics of the radiation beam as generated in the radiation system of a lithographic apparatus. Generally, these characteristics comprise the homogeneity or uniformity of the beam, the size and/or shape of the beam, the pointing direction of the beam, and the divergence of the beam, further indicated as "beam quality characteristics". Until now, only limited options are available in a lithographic system to determine such beam quality characteristics and to control such characteristics. Specifically, when a radiation beam lacks a proper dimensioning and homogeneity, this affects for example the ellipticity of the projection beam, causing a different imaging quality of horizontal and vertical structures on a wafer.

As a rule, a lithographic system comprises a radiation source, such as for example a laser, which provides a radiation beam that is further lead into an illumination system and subsequently towards the patterning means. Such a radiation source is a unit which is generally positioned at a certain distance from the rest of the lithographic apparatus comprising the illumination system, the support structure, the projection system, and the substrate table.

To further guide the beam towards the support structure for supporting patterning means and to control the illumination thereof, an illumination system is used. Hence, in a conventional system, the beam travels from the radiation source to the illumination system, and, before entering the illumination system simple conditioning of the beam is possible, such as manually adjusting an optical conditioning unit such as a beam expander in order to modify the size of the beam in two different directions or directing the beam by one or more steering mirrors.

In order to determine the beam size of a radiation beam travelling through the illumination system, conventionally, a fluorescent raster target is placed in the optical path of the beam and the dimensions of the beam are visually interpreted or graphically recorded by for example a CCD camera. An example of such a camera arrangement is given in US Patent No. 4,916,319. The image from the camera may then by analyzed further. Based on the value of the beam size thus determined, the optical conditioning unit can be manually adjusted. This process is repeated until a proper beam size is achieved, so that the beam is tuned, until a new adjustment of the lithographic system appears necessary.

In order to determine the beam divergence, conventionally, the fluorescent raster target is placed in at least two positions along the optical path of the beam, the difference in beam size between the two positions being indicative for the divergence of the beam. Although considered quite relevant for achieving optimal illumination conditions, no quick or automated procedure exists in order to measure a beam divergence of the beam, which although small, may be able to influence the system in quite a severe manner, since in a lithographic system the imaging pupil will be distorted depending on such quality characteristics.

It is clear that the above procedures for determining beam size and divergence are tedious and time-consuming, let alone mentioning the costs involved of keeping the apparatus in a non-productive state.

In known lithographic apparatus, generally a detector for detecting the intensity of the radiation beam in the illumination system is present. Such a detector is for example an Energy Sensor (ES), which captures a split version of the beam and measures an energy influx, in order to provide a control of the radiation dose delivered to a target portion of the substrate. Another example of such a detector is a positional detector used in a so called Beam Measuring Unit (BMU), the latter able to determine the position and pointing direction of the radiation beam in the illumination system. The BMU comprises focussing elements that image split versions of the beam on two position sensitive devices (PSDs), the position on the first PSD being indicative for the entering position and the position on the second PSD being indicative for the pointing direction of the beam. A PSD can operate as a detector for measuring a radiation intensity when the output signals of the PSD are being summed or integrated.

It is an object of the invention to provide a lithographic apparatus, wherein an improved measurement and control of quality characteristics of a radiation beam for illumination of a substrate is achieved. It is a further object of the invention to provide a lithographic system, wherein such quality characteristics can be measured and controlled without drastic modifications of existent lithographic systems. It is a further object of the invention to use the Energy Sensor (ES) or the Beam Measuring Unit (BMU) to determine and control such quality characteristics of the radiation beam such as beam size and beam divergence. It is a further object to reduce the amount of additional tool equipment and workload needed to provide such control. It is a still further object of the invention to provide a method for determining a beam size and divergence of a radiation beam in a lithographic apparatus, substantially improving the known procedures of adjusting and tuning beam characteristics.

According to the invention, these and other objects are achieved in a lithographic apparatus as specified in the preamble of claim 1, wherein the lithographic apparatus comprises a processor coupled to said means for changing a position of the radiation beam in order to vary the intensity of said radiation beam through said aperture by a relative movement of the radiation beam and said aperture, the processor further coupled to said detector for measuring said intensity, the processor arranged to calculate the beam size as a function of measured intensity and relative movement.

The invention provides a simple technique for identifying such characteristics of interest, thus eliminating the need of long interruptions caused by disassembly of the illumination system and placing separate tool equipment which is not functional during the actual lithographic process. By reducing/increasing the part of the radiation beam that passes through the aperture, the intensity of radiation incident on the detector will be reduced/increased. Hence, by determining the relative displacement of the aperture and the radiation beam while measuring the amount of incident radiation, in a simple way, the size of the beam can be determined. This implies that either the position of the radiation beam or the position of the aperture can be changed. Hence, an improved and actual online control of the light beam quality characteristics is possible by using the lithographic system according to the invention.

In a preferred embodiment, the processor is arranged for receiving a first relative intensity at a first relative position of the radiation beam and for receiving a second relative intensity at a second relative position of the radiation beam; wherein the processor is arranged to calculate the beam size as a ratio of differences of first and second relative positions and first and second relative intensities. Since in middle positions between a complete shut-off of the radiation and a complete pass-through of the radiation a linear relationship exists between the displacement and the measured energy, which holds for rectangular beam cross-sections, from this relationship the total beam size can easily be determined by extrapolation.

In a further embodiment, said means for varying the position of the radiation beam and thereby the intensity passed through the aperture comprises a first tiltable steering mirror coupled to said processor. In such an arrangement the processor may calculate a relative movement of said reflected radiation beam as a function of a received tilt of said steering mirror and as a function of a predetermined beam delivery length between said steering mirror and said aperture. As mentioned before such a steering mirror may already be present in the system, where, by very simple adaptation and measuring of the tilt angle, from a known beam delivery length, the position of the radiation beam at the location of the aperture may be determined. In this respect, the term "beam delivery length" refers to an optical distance traveled by a radiation beam between, in this case, the steering mirror and the aperture.

In such a steering mirror arrangement, the processor may be arranged for receiving a third relative intensity at a third relative position of the radiation beam, wherein the radiation beam at least partially, but preferably 50%, overlaps the aperture on a first side of the aperture and for receiving a fourth relative intensity at a fourth relative position of the radiation beam wherein the radiation beam at least partially, but preferably 50%, overlaps the aperture on a second side of the aperture opposite said first side; wherein the processor is arranged to calculate the beam delivery length as a function of said third and fourth tilt angles and a predetermined distance between said opposite sides of said aperture.

Conveniently, said steering mirror is tiltable in two different directions, so as to be able to determine the beam size in two cross-directions.

In a conventional illumination system, the radiation beam may be further conditioned by controlling the angular distribution of the beam; this is usually performed by a so-called diffractive optical element (DOE). Although for applying the method of the invention, any aperture placed in the optical path of the radiation beam may be used for determining a beam size, in a preferred embodiment, the aperture through which the radiation beam is directed, is formed by the non-transmissive frame of such a diffractive optical element. In that case, the size of the aperture is in the order of 50 x 32 mm. Therefore, as a preferred embodiment, the lithographic system according to the invention is equipped with a conventional steering mirror located at a relatively large distance from the aperture, a conventional diffractive optical element serving as the aperture and a conventional energy sensor ES which is also already present for detecting the amount of energy that is transferred to the substrate, hence, in this respect, no substantive modification of the illumination system is necessary to perform a beam size determination according to the method and apparatus of the invention.

In a further preferred embodiment, the apparatus according to the invention further comprises an optical element for varying the beam size of said radiation beam, said optical element coupled to said processor, so as to tune said radiation beam to a desired beam size. In this way, a direct feedback loop can be formed to control the beam size and inaccurate manual tuning and adjustment of the optical element for varying the beam size can be avoided.

In a still further preferred embodiment of the invention, a focussing element having a predetermined focussing power may be arranged to focus said radiation beam or part of said beam in a focus plane, said aperture being arranged in said focus plane of said focussing element, followed by a detector such as a positional detector. According to the invention the processor may be arranged to determine the size of said focussed radiation beam, for example by moving the aperture relative to the focussed beam; and the processor further arranged to calculate a beam divergence of said radiation beam as a function of said size of said focussed radiation beam. Since such focussing element may already be present, the invention offers, by slight modifications of detection and control systems, an elegant possibility to measure the beam divergence. Therefore, in addition to the earlier described setup for measuring a beam size, in this further preferred embodiment, also beam divergence measurements are possible by using the fact that a parallel beam produces a point-like spot when focussed whereas a diverging beam produces a spot of non-zero size when focussed; the amount of non-parallellicity or divergence is thus reflected in the size of the spot; hence, using said focussing element, such as a focussing lens or mirror, a determination of the divergence is possible. An alternative for determining the size of the focussed radiation beam and thereby the divergence of the beam is to change the pointing direction of the beam, for example by tilting a second steering mirror located relatively close to the aperture, and determining a first pointing direction in which a relatively low intensity passes through the aperture (for example 10%) and a second pointing direction in which a relatively high intensity passes through the aperture (for example 90%). The beam divergence is then directly calculated from the difference between these first and second pointing directions and the relative intensities detected at these pointing directions.

In an optical path of said radiation beam, said first steering mirror may be provided relatively far from an aperture followed by a second steering mirror which is located relatively close to an aperture, in such a way, that said first steering mirror changes substantially a relative position of said radiation beam and said second steering mirror changes substantially a pointing direction of said radiation beam. In this arrangement, both beam size and divergence can be determined.

According to a further aspect of the invention there is provided a method of determining a beam size of a radiation beam in a lithographic apparatus, comprising:

   providing a radiation beam;
   providing an aperture;
   providing a detector for measuring an intensity of the radiation beam through said aperture;
   changing a position of the radiation beam relative to said aperture;
   measuring the intensity of the radiation beam through the aperture relative to a maximum intensity as a function of relative movement of the radiation beam; and
   calculating the beam size of the radiation beam from the measured intensity as a function of relative movement.

In a first embodiment according to the method of the invention, the method may comprise detecting a first relative intensity at a first relative position of the radiation beam; detecting a second relative intensity at a second relative position of the radiation beam; and calculating the beam size as a ratio of differences of first and second relative positions and first and second relative intensities. Preferably said first and second relative positions correspond to 10% and 90% relative intensity of the radiation beam. The method may further comprise providing a first tiltable steering mirror;
   reflecting said radiation beam by said steering mirror;
   measuring a relative movement of said reflected radiation beam as a function of tilt angle of said steering mirror and as a function of a predetermined beam delivery length between said steering mirror and said aperture.

In this arrangement, the method may comprise detecting a third relative intensity at a third relative position of the radiation beam corresponding to a third relative tilt angle of the steering mirror, wherein the radiation beam at least partially overlaps the aperture on a first side; detecting a fourth relative intensity at a fourth relative position of the radiation beam corresponding to a fourth relative tilt angle of the steering mirror, wherein the radiation beam at least partially overlaps the aperture on a second side opposite said first side; and calculating the beam delivery length as a function of said third and fourth tilt angles and a predetermined distance between said opposite sides of said aperture. Said third and fourth relative positions may correspond to 50% relative intensity of the radiation beam. Said beam size may be measured in two different directions, more particular, the radiation beam may be moved relative to the aperture in two different directions.

In a further preferred embodiment, the method may comprise providing a beam of radiation; providing a focussing element; focussing said radiation beam in a focus plane by said focussing element; and determining the size of the spot of radiation in said focus plane as a measure of the beam divergence.

Preferably said measurement is performed by a spot size measurement similar to the above described beam size measurement; however the invention is not limited thereto; other measurement methods for determining the beam divergence of said radiation beam may be applied.

In a preferred embodiment, the (absolute) divergence of said radiation beam may be calculated from the measured intensity as a function of pointing direction.

In this way, an elegant way for determining the beam divergence is offered. Said focussed radiation beam may be incident on a positional detector, such as a Position Sensitive Device PSD, arranged in or adjacent to the focus plane of said focussing element. A relative incident position of said focussed radiation beam on said positional detector is normally indicative for the average direction of the radiation beam. The positional detector may comprise a fixed aperture, the size of the aperture being in the order of 9 x 9 mm.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid crystal display panels, thin film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Embodiments of the invention will now be described, by way of example only, with reference to the accompanying schematic drawings in which corresponding reference symbols indicate corresponding parts, and in which:

Figure 1 depicts a lithographic apparatus according to an embodiment of the invention;
Figure 2 schematically depicts the LA-Ex-2-IL elements of fig. 1;
Figure 3 schematically illustrates a diagram of an ES signal in relation to a tilt angle of a steering mirror; corresponding relative positions of the radiation beam and the aperture are depicted below said diagram;
Figure 4 depicts an energy signal measured in two dimensions for relative tilts in an X- and Y-direction;
Figure 5 depicts a more detailed illustration of the Beam Measuring Unit illustrated in figure 2;
Figure 6 depicts the focussing of a parallel (a), a diverging (b), and a converging radiation beam (c);
Figure 7 depicts measurement results for changing the pointing of the beam in the X-direction;
Figure 8 depicts measurement results for changing the pointing of the beam in the Y-direction.

Embodiment 1 - measuring beam size.

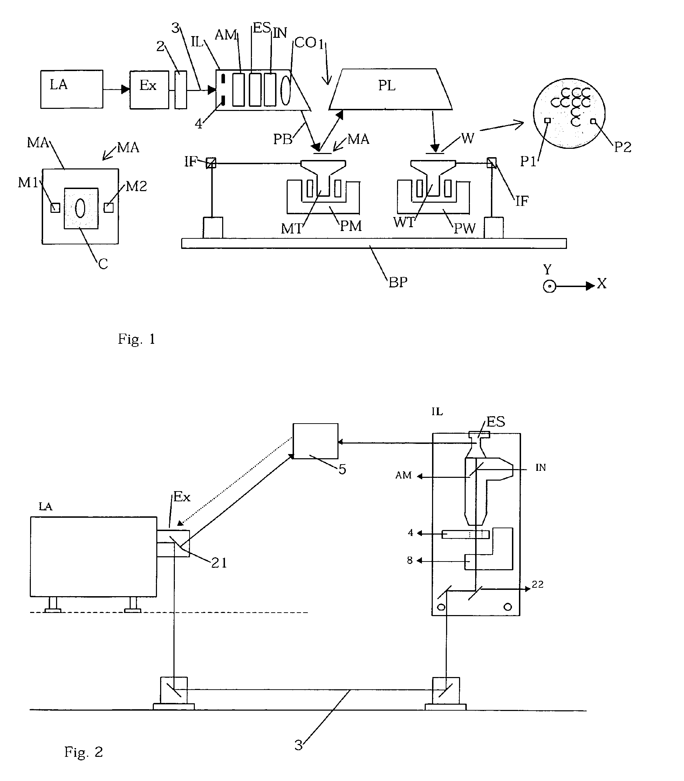

Figure 1 schematically depicts a lithographic apparatus 1 according to a particular embodiment of the invention. The apparatus comprises:

- a radiation system LA, Ex, 2, IL, for supplying a projection beam PB of radiation (e.g. light in the deep ultraviolet region).
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resistcoated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W.

As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The radiation source LA (e.g. an excimer laser source) produces a beam of radiation. This beam is fed into an illumination system (illuminator) IL, either directly or after having traversed optical conditioning means, such as a beam expander Ex, or one or more directing mirrors 2. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic apparatus (as is often the case when the source LA is a mercury lamp, for example), but that it may also be remote from the lithographic apparatus, the radiation beam which it produces being led into the apparatus (e.g. with the aid of suitable directing mirrors 2); this latter scenario is often the case when the source LA is an excimer laser. The directing mirrors and the optical conditioning system Ex such as a beam expander need not be physically separated systems but they can also be intermixed, for example the beam expander comprising one of the directing mirrors. The current invention and claims encompass both of these scenarios.

The beam PB subsequently intercepts the mask MA, which is held on a mask table MT. Having traversed the mask MA, the beam PB passes through the lens PL, which focusses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:

1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

In the lithographic apparatus 1 a radiation beam 3 is guided through an aperture 4 which is present in the illumination system IL; directing mirrors 2 for directing the radiation beam 3 through said aperture 4 are present and a detector ES for detecting an intensity of the radiation beam through said aperture, for example an energy sensor. For determining the beam size, in the prior art systems a raster target is used, that is specifically for this purpose placed manually in the illumination system IL. This procedure is time-consuming, incorporates a safety risk as UV radiation is employed, and may contaminate the illumination system. Furthermore, the image acquired by the raster target is not easily readable.

In figure 2, a more detailed illustration is shown of the LA-Ex-2-IL elements of figure 1. In the figure, the radiation source LA is a deep ultraviolet (DUV) excimer laser, although the invention is also applicable for other types of radiation sources. Further, the light beam emanating from the laser is conditioned by the optical conditioning unit EX, which is a unit for adjusting the beam size in the X- and Y-direction. Conventionally, this unit comprises a manually adjustable lens system that is movable along an optical axis, the position of the lenses determining the size in the X- and/or Y-direction. In the optical conditioning unit Ex a tiltable steering mirror 21 is also present, a tilt of which causes, depending on the axis of rotation, a lateral displacement in X- or Y-direction of the beam near the aperture 4. In this way, the beam 3 can be directed through the aperture 4, which, in this embodiment, is formed by the edges of the frame of a diffractive optical element (DOE) in an automated DOE-exchanger. From such an exchanger, a DOE is selected for further conditioning the beam in a desired way. The conditioning generally comprises controlling the angular distribution of the beam.

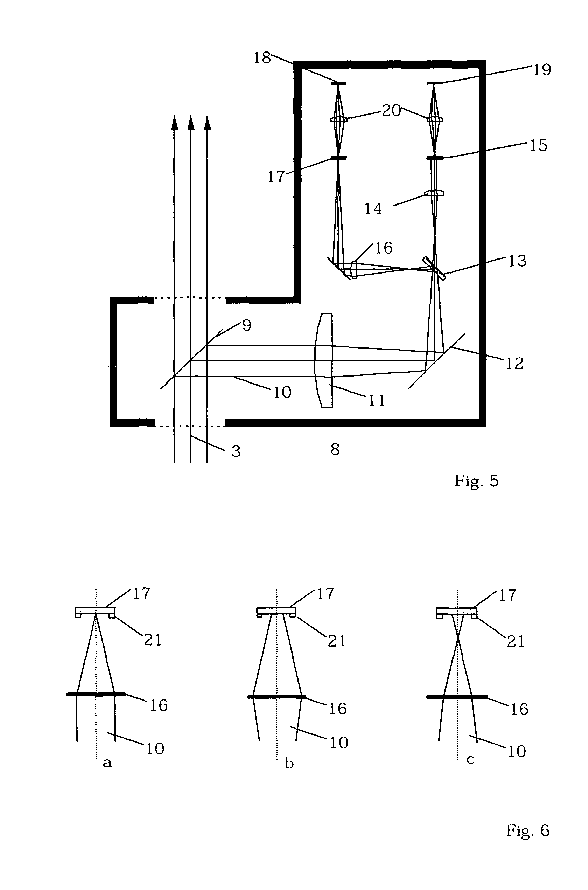

In the illumination system IL a fraction of the radiation beam is guided into the Beam Measuring Unit 8, which is present for measuring the position and pointing direction of the radiation beam and will further be explained with reference to figure 5. The majority of the beam travels through the DOE and the aperture 4 and is guided into the Zoom Axicon AM, which is there for setting the outer and/or inner radial extent (commonly referred to as σ-outer and σ-inner, respectively) of the intensity distribution in the beam. A fraction of the energy of the light beam is guided into Energy Sensor ES, the rest is directed to further elements of the illumination unit, such as the integrator IN and condensor CO.

The output signal of the Energy Sensor is related to the amount of energy that is incident on the wafer in the wafer stage, which amount is relevant for the photosensitive materials applied in photolithography. In this embodiment, the size of beam 3 is measured by a processor 5 coupled to the steering mirror 21, the processor measuring a tilt angle in relation to a measured energy signal from energy sensor ES.

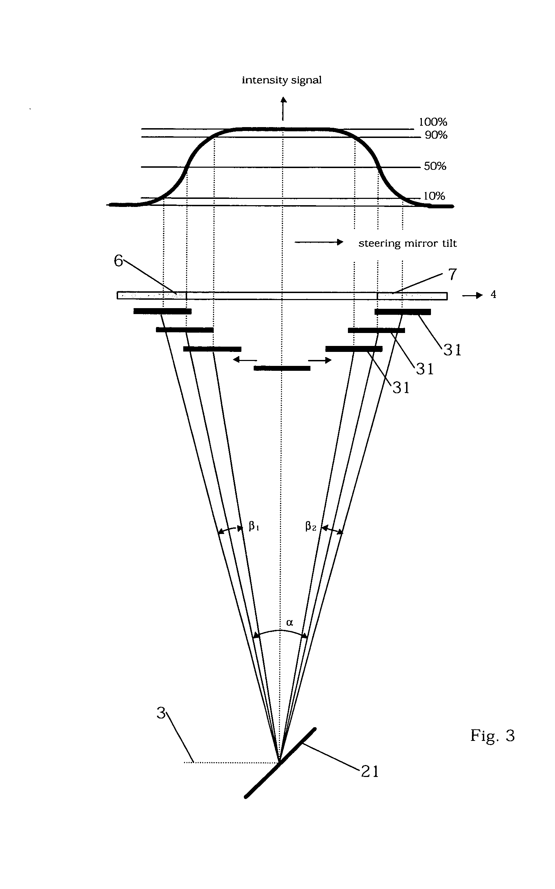

Referring to figure 3, a relation is shown between a tilt angle of steering mirror 21 and the energy signal that is measured by ES. In order to vary the intensity of said radiation beam through said aperture by a relative movement of the radiation beam and said aperture, the processor is coupled to the steering mirror 21 and is further coupled to said detector ES for measuring said intensity. The processor 5 in fig. 2 is arranged to calculate the beam size from the obtained energy values as a function of angular displacement.

Figure 3 can be understood as follows: Starting from a tilt directing the beam to the far left side of the positionally fixed aperture 4, the beam is blocked by edge 6 of the aperture 4. Then, by rotating the steering mirror 21 clockwise, the beam intensity through DOE 4 is increased according to the functional relationship depicted in the upper diagram of the figure. By continuing the rotation, eventually, the beam 3 is blocked partially and eventually completely by the opposite edge 7 of aperture 4.

The steps for determining the beam size 31 are now as follows: First, the beam delivery length is determined from the 50% points in the energy diagram, which is equivalent to a tilt angle $\alpha$ as indicated in fig. 3:

$$beam\ delivery\ length = \frac{aperture\ size}{2 \cdot tan(^{\alpha}/_2)} \qquad [1]$$

Then, the difference in angle between two rotational positions of the mirror 21 is measured, wherein in a first position the measured intensity is relatively low, for example 10%, and in a second position the measured intensity is relatively high, for example 90% of the maximum intensity. These two angular positions at a first side of the aperture define $\beta_1$, and these two angular positions at a second opposite side define $\beta_2$. The average of $\beta_1$ and $\beta_2$ is defined as $\beta$, which is subsequently used to calculate the beam size according to the following formula:

$$beam\ size = C \cdot tan(\beta) \cdot beam\ delivery\ length \qquad [2]$$

wherein the constant C depends on the specific relative intensities at the first and second position. In this particular case, only 80% of the beam size (i.e. the 10% - 90% points) is actually measured, hence C equals 1.25, assuming a substantially linear relationship between energy intensity and angular displacement which is true for rectangular beam cross-sections. The processor is arranged to calculate the beam size as a ratio of differences of first and second relative positions and first and second relative intensities.

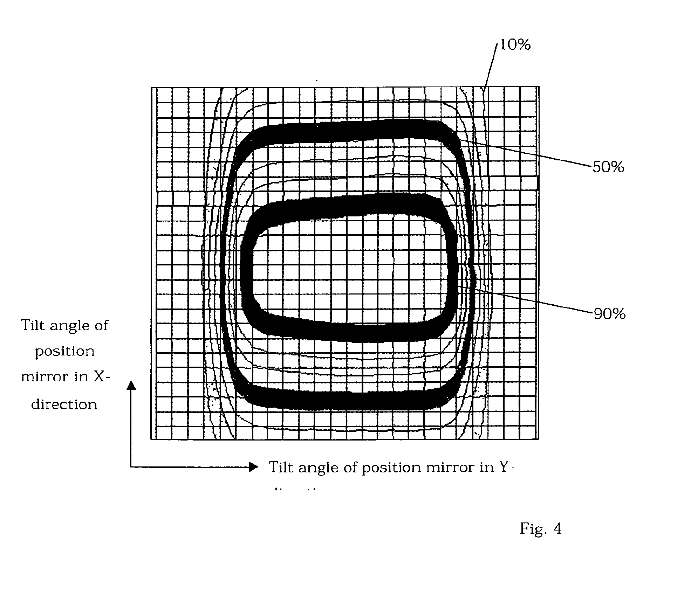

In fig. 4, a two-dimensional plot is shown of actual measurement results in a lithographic system, wherein for a matrix of 25 x 25 tilt angles the energy intensity was measured. From this two-dimensional plot, the size of the beam can be calculated along a cross-section, where the 10, 50 and 90% points are determined by linear interpolation. It is apparent that the size of the radiation beam is larger in the X-direction than in the Y-direction since 10% and 90% relative intensity lines are spaced closer in the Y-direction.

The results of a typical beam size determination are given in the following table 1:

Table 1

| parameter | Tilt angle upper side [mrad] | Tilt angle lower side [mrad] |
|---|---|---|
| 10% | -3.83 | 5.44 |
| 50% | -1.02 | 7.99 |
| 90% | 1.45 | 10.55 |
|  |  |  |

Table 1   (continued)

| parameter | Tilt angle upper side [mrad] | Tilt angle lower side [mrad] |
|---|---|---|
| α | 9.01 mrad | |
| β | 5.28 mrad | 5.11 mrad |
| aperture size | 50 mm | 50 mm |
| beam size in X | 36.6 mm | 35.5 mm |

Next, a check was performed by measuring the beam size via a conventional camera tool placed in the BMU and a frame grabber looking on the raster target. The result (37 mm) matched perfectly with the calculated values from table 1.

Embodiment 2 -measuring beam divergence.

In fig. 5, a detailed illustration is given of beam measuring unit BMU 8. From the radiation beam 3 (DUV laser beam) that propagates in the direction of the zoom-axicon AM, 1% is split off by the incoupling mirror 9. The split beam 10 travels through lens 11 and via a reflective mirror 12 to a second semi-reflective mirror 13, which splits the DUV laser beam 10 in two halves. The part that passes mirror 13 is imaged by lens 14 on a fluorescent target 15 (in this example: YAG:Ce). The other part of the beam that is reflected by mirror 13 is focussed by lens 16 on a second fluorescent target 17. The construction of both optical paths is such that the combination of lens 11 and 14 makes an image of the DUV laser beam on the fluorescent YAG:Ce target 15, while the combination of lens 11 and 16 focusses the DUV laser beam 10 on the fluorescent target 17. Consequently lens combination 11 and 14 is used for measuring the position of the beam, while lens combination 11 and 16 is used for measuring the pointing direction of the laser beam. The deep ultraviolet light is absorbed in the YAG:Ce crystal. This crystal emits visible light that is imaged 1:1 on Position Sensitive Devices (PSDs) 18 and 19 with lenses 20.

The radiation beam will be focussed to a point-like spot on target 17 (see Fig. 6a) in case of a purely parallel beam and if lenses 11 and 16 are properly aligned/positioned. If the beam is diverging or converging, the focussed beam will result in a spot with non-zero size (see respectively Fig. 6b and 6c). The size of this spot on target 17 is a measure for the divergence or convergence of the beam and can be measured by scanning the spot with the second beam steering mirror 22 over the diaphragm 21 in front of the target 17 or in front of the PSD 18, as explained with reference to embodiment 1. For this divergence determination, the sum signal of the pointing PSD 18 should be used as a measure of the total radiation intensity through the aperture.

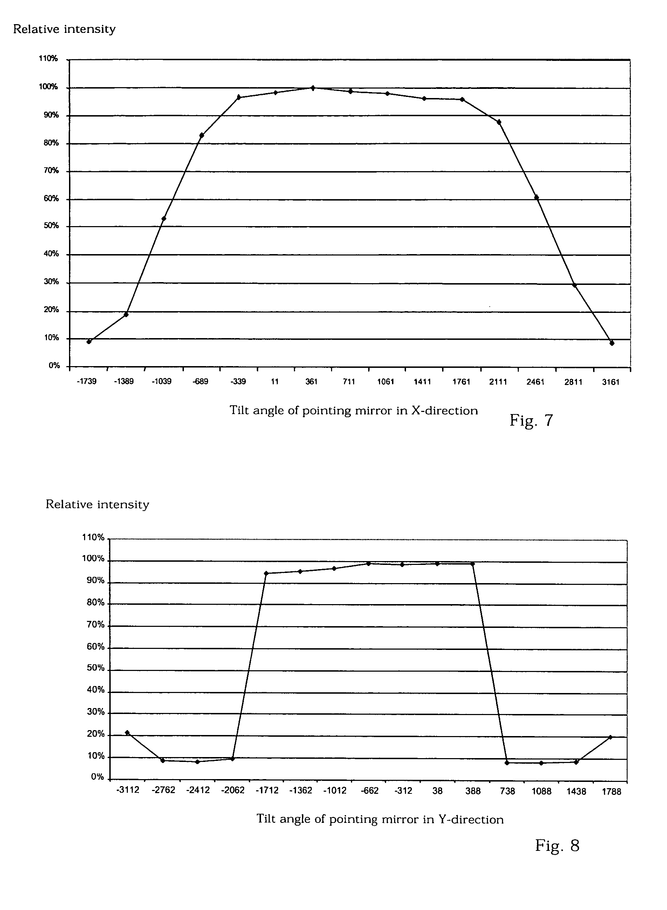

Next, the results of a beam divergence determination are illustrated in figs. 7 and 8. The results of figure 7 are listed in table 2. The tilt angle is converted from steps of a rotational encoder to mrads.

Table 2

| parameter | Tilt angle left side [steps] | Tilt angle left side [mrad] | Tilt angle right side [steps] | Tilt angle right side [mrad] |
|---|---|---|---|---|
| 10% | -1703 | -3.04 | 3140 | 3.59 |
| 50% | -1070 | -1.91 | 2580 | 4.59 |
| 90% | -508 | -0.91 | 2009 | 5.56 |
| | | | | |
| α | | | 6.50 mrad | |
| β | | 2.13 mrad | | 1.97 mrad |

Angle β is the difference in tilt angle between the two positions of the second steering mirror 22 where 10% and 90% of the maximum sum signal of the pointing PSD 18 and is a direct measure for the beam divergence in the X- and Y-direction. Angle β [mrad] can be derived from the beam steering mirror 22 rotational position [steps] after a standard calibration procedure.

$$beam\ divergence \equiv \beta = C \cdot |Tilt\ angle\ 10\% - Tilt\ angle\ 90\%| \qquad [3]$$

where constant C equals 1.25 when tilt angles are used corresponding to 10% and 90% of the total beam divergence.

Table 3 shows the results of a typical divergence measurement according to the invention compared to a conventional divergence measurement with a photographical recording on a predetermined number of positions in the optical path of the radiation beam. It is noted that the beam divergence measured according to the method of the invention is in accordance with the conventional beam divergence measurement method.

Table 3

| Parameter | method according to the invention [mrad] | conventional method [mrad] |
|---|---|---|
| beam divergence X | 1.25 * 2.15 = 2.69 | $2.9 \pm 0.2$ |
| beam divergence Y | 1.25 * 0.21 = 0.26 | $0.14 \pm 0.2$ |

It is noted that while in the described embodiments, a single scan in one dimension is performed for measuring a beam size; actually, a beam size may be scanned multiple times for obtaining an accurate 2D impression of the beam cross-section. It is noted that where applicable in the text, when the term optical or focussing element is used such may be a composite element or a set of separate objects providing the same effect. Whilst specific embodiments of the invention have been described above, it will be appreciated that the invention may be practiced otherwise than as described. The description is not intended to limit the invention.

**Claims**

1. A lithographic apparatus comprising:

   - a radiation system for providing a projection beam of radiation;
   - a support structure for supporting patterning means, the patterning means serving to pattern the projection beam according to a desired pattern;
   - a substrate table for holding a substrate;
   - a projection system for projecting the patterned beam onto a target portion of the substrate;
   - an aperture, through which a radiation beam is directed;
   - a detector for measuring an intensity of the radiation beam through said aperture; and
   - means for changing a position of the radiation beam;

   **characterized in that** the lithographic apparatus further comprises a processor coupled to said means for changing a position of the radiation beam in order to vary the intensity of said radiation beam through said aperture by a relative movement of the radiation beam and said aperture, the processor further coupled to said detector, the processor arranged to calculate a beam size of the radiation beam from the measured intensities and relative movements.

2. A lithographic apparatus according to claim 1, wherein the processor is arranged for receiving a first relative intensity at a first relative position of the radiation beam and a second relative intensity at a second relative position of the radiation beam and for calculating the beam size as a ratio of differences of first and second relative positions and first and second relative intensities.

3. A lithographic apparatus according to claim 2, wherein said first and second relative positions correspond to 10% and 90% relative intensities of the radiation beam and said beam size is calculated from a distance between said first and second relative positions.

4. A lithographic apparatus according to any of the claims 1-3, wherein said means for changing the position of the radiation beam comprises a tiltable steering mirror located at a relatively large distance from the aperture and coupled to said processor; and wherein said processor is arranged to calculate a relative movement of said reflected radiation beam as a function of a received tilt angle of said steering mirror and as a function of a predetermined beam delivery length between said steering mirror and said aperture.

5. A lithographic apparatus according to claim 4, wherein the processor is arranged for receiving a third relative intensity at a third relative position of the radiation beam at which the radiation beam at least partially overlaps the aperture on a first side of the aperture and for receiving a fourth relative intensity at a fourth relative position of the radiation beam at which the radiation beam at least partially overlaps the aperture on a second side of the aperture opposite said first side, the processor further arranged to calculate the beam delivery length as a function of a third and fourth tilt angle corresponding to said third and fourth relative positions of the radiation beam and a predetermined distance between said opposite sides of said aperture.

6.  A lithographic apparatus according to any of the claims 4-5 , wherein said steering mirror is tiltable in two different directions.

7.  A lithographic apparatus according to any of the claims 1-6, **characterized in that** said aperture is formed by edges of a frame of a diffractive optical element.

8.  A lithographic apparatus according to any of the claims 1-7, further comprising an optical element for varying the beam size of said radiation beam, said optical element coupled to said processor, so as to tune said radiation beam to a desired beam size.

9.  A lithographic apparatus comprising:

    -   a radiation system for providing a projection beam of radiation;
    -   a support structure for supporting patterning means, the patterning means serving to pattern the projection beam according to a desired pattern;
    -   a substrate table for holding a substrate;
    -   a projection system for projecting the patterned beam onto a target portion of the substrate;
    -   a focussing element arranged to focus part of a radiation beam in a focus plane;
    -   an aperture arranged in said focus plane of said focussing element;
    -   a detector for detecting an intensity of the radiation beam through said aperture; and
    -   means for changing a pointing direction of the radiation beam;

    **characterized in that** the lithographic apparatus further comprises a processor coupled to said means for changing the pointing direction of the radiation beam in order to vary the intensity of said radiation beam through said aperture by a change in pointing direction of the radiation beam, the processor further coupled to said detector, the processor arranged to calculate a beam divergence of the radiation beam from the measured intensities and pointing directions.

10. A lithographic apparatus according to claim 9, wherein said means for changing the pointing direction of the radiation beam comprises a steering mirror tiltable in two different directions and located at a relatively small distance from said aperture so as to change substantially the pointing direction of the radiation beam by tilting said steering mirror.

11. A lithographic apparatus according to any of the claims 9-10, wherein said detector comprises one of an energy sensor and a positional detector.

12. Method of determining a beam size of a radiation beam in a lithographic apparatus, the method comprising:

    -   providing a radiation beam;
    -   providing an aperture;
    -   providing a detector for measuring an intensity of the radiation beam through said aperture;
    -   changing a position of the radiation beam relative to said aperture;
    -   measuring the intensity of the radiation beam through the aperture relative to a maximum intensity as a function of relative movement of the radiation beam; and
    -   calculating the beam size of the radiation beam from the measured intensity as a function of relative movement.

13. Method according to claim 12, **characterized in that** calculating the beam size comprises:

    -   determining a first relative intensity at a first relative position of the radiation beam;
    -   determining a second relative intensity at a second relative position of the radiation beam; and
    -   calculating the beam size as a ratio of differences of first and second relative positions and first and second relative intensities.

14. Method according to claim 13, wherein said first and second relative positions correspond to 10% and 90% relative intensities of the radiation beam.

15. Method according to any of the claims 12-14, further comprising:

- providing a tiltable steering mirror at a relatively large distance from said aperture;
- reflecting said radiation beam by said steering mirror so as to change substantially a position of the radiation beam at the aperture by tilting the steering mirror; and
- calculating the relative movement of said reflected radiation beam as a function of a tilt angle of said steering mirror and as a function of a predetermined beam delivery length between said steering mirror and said aperture.

16. Method according to any of the claims 12-15, wherein said steering mirror is tilted in two different directions and said beam size is measured in two different directions.

17. Method according to any of the claims 12-16, the method further comprising:

- varying the beam size of said radiation beam, so as to tune said radiation beam to a desired beam size.

18. Method according to claim 15, further comprising:

- measuring a third relative intensity at a third relative position of the radiation beam corresponding to a third relative tilt angle of the steering mirror, wherein the radiation beam at least partially overlaps the aperture on a first side;
- measuring a fourth relative intensity at a fourth relative position of the radiation beam corresponding to a fourth relative tilt angle of the steering mirror, wherein the radiation beam at least partially overlaps the aperture on a second side opposite said first side;
- calculating the beam delivery length from said third and fourth tilt angles and a predetermined distance between said opposite sides of said aperture.

19. Method according to claim 18, wherein said third and fourth relative positions of the radiation beam correspond to 50% relative intensity through the aperture.

20. Method of determining a beam divergence of a radiation beam in a lithographic apparatus, the method comprising:

- providing a radiation beam;
- providing a focussing element;
- providing an aperture in a focus plane of said focussing element;
- providing a detector for measuring an intensity of the radiation beam through said aperture;
- focussing part of said radiation beam in a focus plane by said focussing element;
- changing a pointing direction of said radiation beam;
- measuring the intensity of the radiation beam through the aperture relative to a maximum intensity as a function of the pointing direction of the radiation beam; and
- calculating the beam divergence of the radiation beam from the measured intensity as a function of pointing direction.

21. Method according to claim 20, **characterized in that** calculating the beam divergence comprises:

- determining a first relative intensity at a first pointing direction of the radiation beam;
- determining a second relative intensity at a second pointing direction of the radiation beam; and

calculating the beam divergence as a ratio of differences of first and second pointing directions and first and second relative intensities..

22. Method according to any of the claims 20-21, wherein said detector comprises one of an energy sensor and a positional detector.

**23.** Method according to any of the claims 20-22, wherein the pointing direction of said radiation beam is changed by reflecting the radiation beam on a steering mirror located at a relatively small distance from the aperture and tilting said steering mirror in two different directions so as to change substantially the pointing direction of said radiation beam.

**24.** Method according to any of the claims 12-23, wherein the beam size of the radiation beam and the beam delivery length are measured by tilting a first steering mirror; and wherein the beam divergence of the radiation beam is determined by tilting a second steering mirror, said first steering mirror provided before said second steering mirror in an optical path of said radiation beam, such that said first mirror substantially changes a relative position of the radiation beam and said second mirror substantially changes a pointing direction of the radiation beam.

Fig. 1

Fig. 2

Fig. 3

Fig. 4

Fig. 5

Fig. 6

Relative intensity

Tilt angle of pointing mirror in X-direction

Fig. 7

Relative intensity

Tilt angle of pointing mirror in Y-direction

Fig. 8